# EUROPÄISCHE PATENTSCHRIFT

(11) **EP 1 008 186 B1**
(45) Veröffentlichungstag und Bekanntmachung des Hinweises auf die Patenterteilung: **14.02.2007**
(21) Anmeldenummer: 98948753.3
(22) Anmeldetag: 07.08.1998
(51) Int. Cl.: H01L 29/73, H01L 23/48

(54) **LEISTUNGSTRANSISTORZELLE**
POWER TRANSISTOR CELL
CELLULE DE TRANSISTORS DE PUISSANCE

(30) Priorität: 08.08.1997 DE 19734509
(43) Veröffentlichungstag der Anmeldung: 14.06.2000
(73) Patentinhaber: Infineon Technologies AG, 81541 München (DE)
(72) Erfinder: ZWICKNAGL, Hans-Peter, D-70565 Stuttgart (DE); BAUREIS, Peter, D-90513 Zirndorf (DE); MÜLLER, Jan-Erik, D-85521 Ottobrunn (DE)
(74) Vertreter: Kottmann, Heinz Dieter
(86) Internationale Anmeldenummer: PCT/DE1998/002283
(87) Internationale Veröffentlichungsnummer: WO 1999/008326

(56) Entgegenhaltungen:
- DE-A- 19 614 584
- GB-A- 2 278 017
- US-A- 5 308 440
- MIURA T ET AL: "HIGH EFFICIENCY ALGAAS/GAAS POWER HBTS AT A LOW SUPPLY VOLTAGE FOR DIGITAL CELLULAR PHONES" GAAS IC SYMPOSIUM: IEEE GALLIUM ARSENIDE INTEGRATED CIRCUIT SYMPOSIUM TECHNICAL DIGEST 1996, ORLANDO,FL, NOV. 3 - 6, 1996, Nr. SYMP. 18, 3. November 1996, Seiten 91-94, XP000659838 INSTITUTE OF ELECTRICAL AND ELECTRONICS ENGINEERS in der Anmeldung erwähnt
- DETTMER R ET AL: "EFFECT OF DEVICE LAYOUT ON THE THERMAL RESISTANCE OF HIGH-POWER THERMALLY-SHUNTED HETEROJUNCTION BIPOLAR TRANSISTORS" 1996 IEEE MTT-S INTERNATIONAL MICROWAVE SYMPOSIUM DIGEST, SAN FRANCISCO, JUNE 17 - 21, 1996, Bd. 3, 17. Juni 1996, Seiten 1607-1610, XP000720650 RANSON R G (ED ) in der Anmeldung erwähnt

## Beschreibung

Die vorliegende Erfindung betrifft Leistungstransistorzellen, insbesondere Heterobipolartransistor-Leistungszellen oder MMIC-Leistungszellen, die durch Luftbrücken thermisch optimiert sind.

Heterobipolartransistoren (HBT) werden für viele Anwendungen im Mikrowellenbereich benötigt, z. B. für mobile Kommunikationstechniken. Die besonderen Vorteile der HBT und der HBT-MMIC (monolithic microwave integrated circuit) sind ihre hohe Stromtragfähigkeit mit hohen Stromdichten, die dabei erzielte hohe Leistungsverstärkung und der entsprechend hohe Wirkungsgrad. Diese Vorzüge können aufgrund der schlechten thermischen Leitfähigkeit des Substratmateriales aus Halbleiter (z. B. Galliumarsenid GaAs) häufig nicht genutzt werden. Es ist daher erforderlich, für eine ausreichende Ableitung der in den Zellen entstehenden Wärme zu sorgen. Bisher wurden verschiedene Mittel eingesetzt, um für eine ausreichende Wärmeableitung zu sorgen. Die verwendeten Substrate können z. B. auf eine Dicke, die dem Abstand der Wärmequellen entspricht, gedünnt werden. Es können metallgefüllte, in die Rückseite des Substrates geätzte Wannen als Wärmesenken unterhalb der Transistoren verwendet werden. Es können von der Rückseite des Substrates zu den Anschlußkontaktflächen auf der Oberseite Durchbrüche (via holes), die mit Gold beschichtet sind, zur Wärmeableitung verwendet werden. Die Transistoren können in Flip-chip-Aufbautechnik montiert werden. Es ist auch möglich, die Transistoren von den Emitteranschlußflächen aus über Stützpfeiler (bumps) auf Wärmesenken zu montieren und die Kollektor- und Basisbereiche auf der Rückseite des Substrates anzuschließen. Für die elektrische Verbindung sind entsprechende Durchbrüche (via holes) vorhanden. Es ist außerdem möglich, die Halbleiterschichten des Transistors epitaktisch auf gut wärmeleitendes Substrat aufzuwachsen. Die negativen Einflüsse der Wärmeentwicklung auf die Stromstabilität des Transistors können außerdem durch Emitter- oder Basis-Ballastwiderstände vermindert werden, was jedoch zu Lasten der Hochfrequenz-Betriebseigenschaften (performance) des Transistors geht.

Eine Möglichkeit der direkten Wärmeableitung über die elektrischen Anschlüsse der Transistorbereiche ist durch die Verwendung von Luftbrücken gegeben. Derartige Luftbrücken sind aus elektrisch und thermisch leitfähigem Material, vorzugsweise einem geeigneten Metall, hergestellt und verbinden brückenartig die Kontakte der einzelnen Transistoren einer Zelle elektrisch und thermisch untereinander. Derartige Luftbrücken sind in den folgenden Veröffentlichungen beschrieben: L. L. Liou et al.: "The Effect of Thermal Shunt on the Current Instability of Multiple-Emitter-Finger Heterojunction Bipolar Transistors", IEEE 1993 Bipolar Circuits and Technology Meeting, pp. 253-256, 1993; B. Bayraktaroglu et al.: "Very High-Power-Density CW Operation of GaAs/AlGaAs Microwave Heterojunction Bipolar Transistors", IEEE Electron Device Letters 14, 493-495 (1993); T. Miura et al.: "High Efficiency AlGaAs/GaAs Power HBTs at a Low Supply Voltage for Digital Cellular Phones", GaAs IC Symposium 1996 Dig., pp. 91-94, 1996; R. Anholt et al.: "Decoupled Electrical/Thermal Modeling of AlGaAs/GaAs Heterojunction Bipolar Transistors", IEEE GaAs IC Symposium Dig. 1996, pp. 167-170, 1996; R. Dettmer et al.: "Effect of Device Layout on the Thermal Resistance of High-Power Thermally-Shunted Heterojunction bipolar Transistors", IEEE MTT-S International Microwave Symposium Dig. 1996, pp. 1607-1610, 1996. Bei diesen HBT werden jeweils die Emitterfinger mit einer Luftbrücke untereinander verbunden. Eine Verbindung der Kollektormetall-Anschlüsse der einzelnen HBT-Unterzellen über Luftbrücken ist z. B. beschrieben in der Veröffentlichung von H.-F. Chau et al.: "High-Power, High-Efficiency K-Band AlGaAs/GaAs Heterojunction Bipolar Transistors", IEEE GaAs IC Symposium 1996 Dig., pp. 95-98, 1996. Es können mehrere der beschriebenen Mittel kombiniert werden.

Aufgabe der vorliegenden Erfindung ist es, eine im Hinblick auf thermische Optimierung weiter verbesserte Leistungstransistorzelle anzugeben.
Diese Aufgabe wird mit der Leistungstransistorzelle mit den Merkmalen des Anspruches 1 gelöst. Ausgestaltungen ergeben sich aus den abhängigen Ansprüchen.

Bei der erfindungsgemäßen Leistungstransistorzelle wird eine Luftbrücke verwendet, die eine wesentliche Ausdehnung nicht nur in der Richtung einer Abfolge von in einer Reihe ausgerichteter Einzeltransistoren aufweist, sondern die auch senkrecht zu dieser Richtung in der Ebene der Substratoberseite wesentlich ausgedehnt ist. Eine solche Luftbrücke kann zum einen besonders dick und damit gut wärmeleitend hergestellt werden und zum anderen über zusätzliche thermische Kontakte auf größer dimensionierten Anschlußkontaktflächen oder auf der Substratoberseite mit einer guten Wärmeableitung oder Wärmesenke versehen sein. In den angegebenen Veröffentlichungen werden Luftbrücken beschrieben, mit denen die Emitterfinger, d. h. die fingerförmigen Emitterkontakte, untereinander mit Luftbrücken verbunden werden, deren Breite nicht größer ist als die Länge der Emitterfinger. Bei den normalerweise kurzen Emitterlängen von 20 µm bis 30 µm wirkt der Wärmetransport solcher im wesentlichen eindimensional gestalteter Luftbrücken nur in einer Richtung entlang der Brücke. Die verhältnismäßig geringe seitliche Ausdehnung der Luftbrücke bietet ein entsprechend kleines Volumen zur Aufnahme der erzeugten Wärme (kleine Wärmekapazität); der gesamte Wärmeabfluß zur Chipoberfläche geschieht nur über die beiden äußersten Transistorzellen. Im Gegensatz dazu ist die bei der erfindungsgemäßen Leistungstransistorzelle vorhandene Luftbrükke möglichst großflächig und besitzt daher eine große Wärmekapazität. Eine wesentliche Ausdehnung der Luftbrücke auch in der Längsrichtung der Emitterfinger ermöglicht es außerdem, mittels auf der Chipoberseite oder auf Kontaktflächen aufgesetzten wärmeleitenden Kontaktpfeilern oder Stützen die Luftbrücke abzustützen und gleichzeitig die Wärme in das Substrat oder in darauf aufgebrachte Metallschichten abzuleiten. Außerdem ist es möglich, derartige wärmeleitende Verbindungen durch Durchbrüche des Substrates auf dessen Rückseite zu führen (via holes). Die bei der erfindungsgemäßen Leistungstransistorzelle vorhandene Luftbrücke wird im folgenden zur Unterscheidung von den in bisherigen Veröffentlichungen beschriebenen Luftbrücken als zweidimensionale Luftbrücke bezeichnet.

Es folgt eine genauere Beschreibung der erfindungsgemäßen Leistungstransistorzellen anhand der Figuren 1-3.
- Figur 1: zeigt eine erfindungsgemäße Zelle mit einer Luftbrücke im Querschnitt.
- Figur 2: zeigt eine erfindungsgemäße Zelle in der in Figur 1 eingezeichneten Aufsicht.
- Figur 3: zeigt ein alternatives Ausführungsbeispiel in Aufsicht.

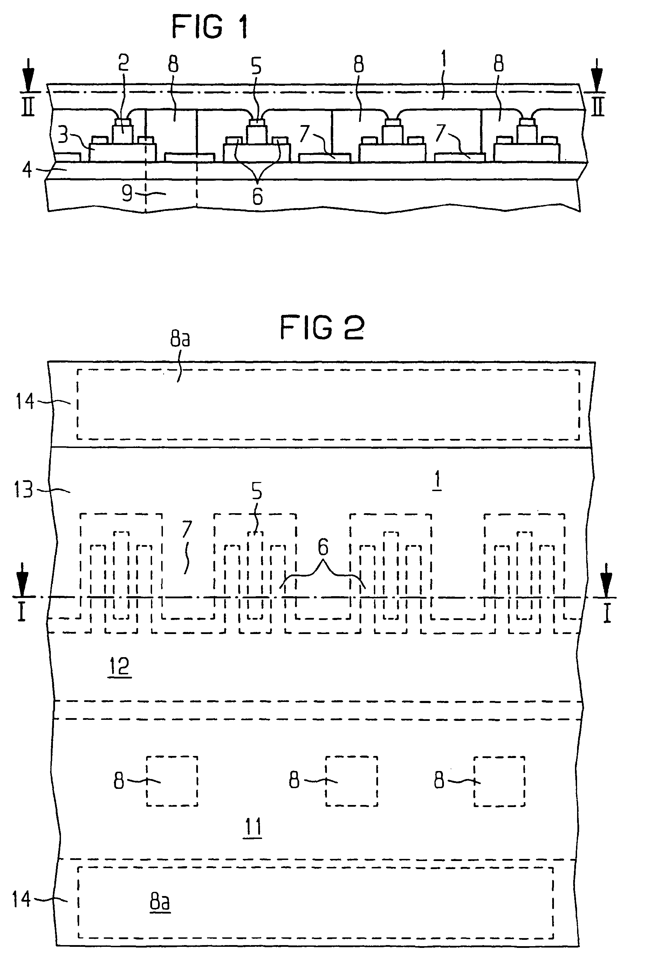

In Figur 1 ist im Querschnitt und etwas schematisiert eine aus mehreren Einzeltransistoren bestehende Leistungszelle dargestellt. Eine thermisch leitfähige und vorzugsweise auch elektrisch leitfähige Luftbrücke 1 verbindet die als Kontakte auf den Emittern 2 aufgebrachten Emitterfinger 5 miteinander. Im Fall einer elektrisch leitfähigen Luftbrücke entfällt ein gesonderter elektrischer Anschluß der Emitterfinger. Auf dem Basisbereich 3 befinden sich jeweils ebenfalls fingerförmig gestaltete Anschlußkontakte als Basisfinger 6. Auf dem Kollektorbereich 4 sind entsprechend Kollektorkontakte 7 aufgebracht. Für die Form der Kontakte ergeben sich erfindungsgemäß keine Einschränkungen gegenüber den bei herkömmlichen Leistungstransistorzellen üblichen Ausgestaltungen, abgesehen von dem Umstand, daß für die Luftbrücke geeignete Aufsetzflächen vorhanden sein müssen. Hinter der Zeichenebene in Blickrichtung angeordnete Kontaktpfeiler 8 sind ebenfalls in Figur 1 eingezeichnet. Mit diesen Kontaktpfeilern wird die thermische und vorzugsweise auch elektrische Verbindung zwischen der Luftbrücke 1 und der Oberseite des Chips oder auf der Oberseite des Chips vorhandener Emitteranschlußflächen hergestellt. Die Fläche, in der die Kontaktpfeiler aufsitzen, sollte vorzugsweise möglichst groß sein. Sie kann die gesamte freie Chipfläche, ausgenommen die Flächen für die Basis- und Kollektoranschlußflächen , einnehmen.

Figur 2 zeigt die Anordnung der Figur 1 in Aufsicht. Es ist die großflächige Luftbrücke 1 hier eingezeichnet mit geradlinigen Berandungen in der Richtung nach oben und unten in der Zeichenebene und mit Bruchlinien links und rechts, die eine weitere Ausdehnung der Luftbrücke andeuten. Die Luftbrücke setzt sich in diesem Beispiel nach links und rechts entsprechend der Anzahl vorhandener Einzeltransistoren fort. Als verdeckte Konturen sind gestrichelt die Emitterfinger 5, die Basisfinger 6 und die Kollektorkontakte 7 sowie die Kontaktpfeiler 8 eingezeichnet. Die Basisfinger 6 sind elektrisch leitend mit einer Basisanschlußfläche 12 verbunden; die Kollektorkontakte 7 sind elektrisch leitend mit einer Kollektoranschlußfläche 13 verbunden. Die eingezeichneten Bestandteile liegen nicht alle in derselben Ebene.

Die Luftbrücke 1 benutzt in dem dargestellten Ausführungsbeispiel sowohl die als Kontakte der Emitter vorgesehenen Emitterfinger 5 der Einzeltransistoren als auch die gemeinsame Emitteranschlußfläche 11 als Aufsetzflächen für die Pfeiler der Luftbrücke. Die Luftbrücke sitzt daher auf den Emitterfingern 5, wie in Figur 1 erkennbar, auf. Die Kontaktpfeiler 8, 8a können teilweise auf der Oberseite 14 des Chips aus Halbleitermaterial (Kontaktpfeiler 8a in Figur 2), teilweise auf der Emitteranschlußfläche 11 (Kontaktpfeiler 8 in Figur 2) aufgesetzt sein. Vorzugsweise sind die Luftbrücke 1 und die Kontaktpfeiler 8 elektrisch leitend, und der elektrische Anschluß der Emitterfinger 5 wird über die auf der Emitteranschlußfläche 11 aufsitzenden Kontaktpfeiler 8 bewirkt. Die gemeinsame Kollektoranschlußfläche 13 wird ganz oder teilweise von der Luftbrücke 1 überspannt. In der Kollektoranschlußfläche 13 wird der gesamte Kollektorstrom aus den Einzeltransitoren aufgesammelt. Die Luftbrücke 1 spannt sich vorzugsweise ebenfalls ganz oder teilweise über die Basisanschlußfläche 12, über die die Basisbereiche der Einzeltransistoren angesteuert werden. Auch die Anschlußflächen können im Prinzip beliebig angeordnet und dimensioniert sein.

Es ist vorteilhaft, wenn die Luftbrücke möglichst großflächig auf der Emitteranschlußfläche aus Metall bzw. auf der Chipoberseite aufgesetzt ist. Der Wärmeabfluß und die Wärmekopplung sind innerhalb der gesamten Oberseite des Substrates möglich. Die bei der erfindungsgemäßen Leistungstransistorzelle wesentlich verbesserte Wärmeverteilung führt zu einer Erniedrigung des thermischen Widerstands der Transistoren im Vergleich zu Transistorzellen mit eindimensionaler Luftbrücke um ca. 30 %, wenn eine etwa 6 µm dicke zweidimensionale Luftbrücke vorhanden ist. Z. B. erreicht man mit einer 6 µm dikken zweidimensionalen Luftbrücke aus Gold in einem 8-Finger-HBT mit einer Emitterfläche von achtmal 3 x 30 µm² einen thermischen Widerstand von 80 K/W im Gegensatz zu etwa 120 K/W bei Verwendung einer eindimensionalen Luftbrücke.

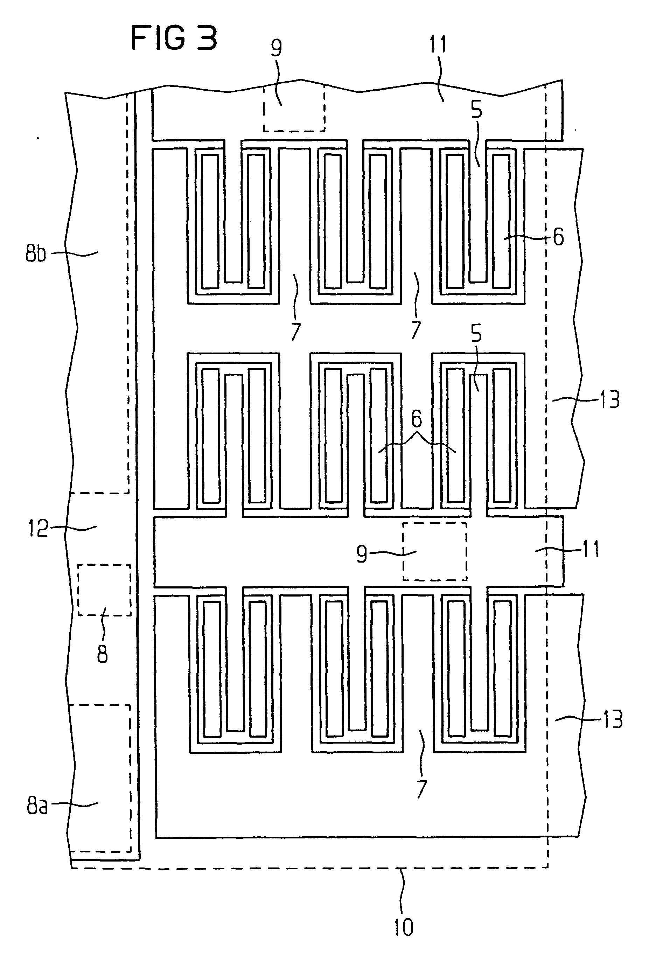

Figur 3 zeigt ein alternatives Ausführungsbeispiel, bei dem die Leistungstransistorzellen mit einer Luftbrücke 10 versehen sind, die die Basisfinger 6 elektrisch und thermisch miteinander verbindet. Die Emitterfinger 5, die Basisfinger 6 und die Kollektorkontakte 7 mit blockweise zugehörigen Emitteranschlußflächen 11, einer gemeinsamen Basisanschlußfläche 12 und ebenfalls blockweise vorgesehenen Kollektoranschlußflächen 13 sind als Beispiel für eine derartige Leistungstransistorzellenanordnung im Ausschnitt gezeichnet. Die darüber angeordnete Luftbrücke 10 ist mit ihrer in der Zeichenebene unteren und rechten geradlinigen Berandung gestrichelt eingezeichnet. Die Transistoranordnung setzt sich in der Zeichenebene nach oben beliebig fort. Die Basisanschlußfläche 12 ist ebenfalls mit ihrer unteren und rechten geradlinigen Berandung eingezeichnet und setzt sich nach links und nach oben entsprechend den eingezeichneten Bruchlinien fort.

Die Luftbrücke 10 ist auf den Basisfingern 6 und mittels Kontaktpfeilern 8 auf der Basisanschlußfläche 12 aufgesetzt. Als Beispiel sind Kontaktpfeiler mit unterschiedlichen Abmessungen auf der Basisanschlußfläche 12 mit gestrichelt gezeichneten Berandungen eingezeichnet. Die Kontaktpfeiler 8a besitzen wesentlich größere seitliche Abmessungen, während ein Kontaktpfeiler 8b den größten Anteil der Basisanschlußfläche 12 bedeckt oder die gesamte Basisanschlußfläche bedecken kann. Auch bei diesem Ausführungsbeispiel kann zumindest ein Anteil der Kontaktpfeiler auf der Oberseite des Chips aus Halbleitermaterial aufsitzen. Zusammen mit einer ausreichenden vertikalen, d. h. senkrecht zur Chipoberseite gemessenen, Dicke der Luftbrücke kann so ein wirksamer Wärmeabfluß von den Basisfingern 6 in die Basisanschlußfläche 12 oder in das Substrat hinein erfolgen.

Die Herstellung der vergleichsweise großflächigen zweidimensionalen Luftbrücke ist mit Standardlithographie und einer üblichen Lackdicke von typisch 3 µm möglich. Die Luftbrücken können gegenüber bisher beschriebenen Luftbrücken auch mit deutlich größerer Dicke (z. B. 20 - 30 µm statt bisher 6 µm) im normalen Verfahren hergestellt werden. Die Einhaltung der dafür erforderlichen Abstände zwischen zwei zweidimensionalen Luftbrücken (abhängig von der Höhe der Luftbrücke) stellt keine Einschränkung dar, da pro Chip im allgemeinen nur wenige Luftbrücken vorhanden sind. Es ist auch möglich, mit dikken Lackschichten zu arbeiten und damit eine entsprechende Dicke bei der Anwendung der Galvanik zu erreichen. Es können daher die beschriebenen Luftbrücken sehr dick, mindestens 20 µm dick, hergestellt werden, so daß der thermische Widerstand sich erneut um typisch 30 % reduziert. Die Brückenbögen der Luftbrücke haben vorzugsweise einen maximalen Abstand von der Chipoberseite von etwa 3 µm bis 5 µm.

Mit der erfindungsgemäßen Leistungstransistorzelle ist das zusätzliche Problem der thermischen Kopplung großer Leistungsblöcke, bei denen mehrere Leistungszellen zusammengeschaltet werden müssen, gelöst. In einer Leistungstransistorzelle sind mehrere Einzeltransistoren zusammengeschaltet. Mehrere Leistungszellen können zu Leistungsblöcken miteinander verbunden werden. Mit einer großflächigen Luftbrücke ist es möglich, die Emitterfinger nicht nur einzelner Leistungszellen, sondern alle Emitterfinger eines solchen Blockes aus mehreren Leistungszellen thermisch miteinander zu koppeln. Die Verbindung der Emitterfinger über eine Luftbrücke kann grundsätzlich auf eine beliebige Anzahl von Leistungszellen erweitert werden. Mit einer großflächigen Luftbrücke kann die Stromstabilität der Leistungszellen so weit verbessert werden, daß Emitter- oder Basisballastwiderstände reduziert oder ganz weggelassen werden können. Das Ausgangskennlinienfeld für den Kollektorstrom bleibt bei Verwendung derartiger Luftbrücken bis zu hohen Kollektor-Emitter-Spannungen stabil. Dieser Effekt kann mit einer herkömmlichen eindimensionalen Luftbrücke nicht erreicht werden.

Der thermische Widerstand bzw. die im Betrieb der Transistorzellen sich einstellende Junction-Temperatur beeinflussen deutlich die Hochfrequenz- und Leistungsdaten der HBT-Zellen und Schaltungen. Eine Erhöhung der Junction-Temperatur um 20 K hat eine Erniedrigung des Gewinnes (gain) um ca. O,4 dB zur Folge. Im Fall einer eindimensionalen Luftbrücke trägt beim Auftreten des Effektes des sogenannten "current hogging" ein Großteil (z. B. eine Hälfte) der Einzeltransistoren nur als unerwünschte parasitäre Kapazitäten bei. Es kommt zu einem Einbruch in der Gleichstromverstärkung, der Ausgangsleistung, dem Wirkungsgrad und dem Hochfrequenzgewinn und zu einer Überlastung der Leistungszelle. Die intensive thermische Verkopplung und verbesserte Wärmeabfuhr bei der erfindungsgemäßen Ausführung bewirkt aufgrund des reduzierten thermischen Widerstandes eine niedrigere und homogen verteilte Junction-Temperatur sowie eine gleichmäßige elektrische Auslastung der Einzeltransistoren. Es lassen sich daher Multi-Emitter-HBT mit wesentlich größeren Emitterflächen bei gleichzeitig hohem Gewinn realisieren.

Alternative Ausführungsformen der erfindungsgemäßen Leistungstransistorzellen sind HBT-MMICs. Es können damit Leistungstransistoranordnungen mit deutlich verkleinerter (typisch ca. um einen Faktor 6) Chipfläche realisiert werden.

Die Ausführungsform gemäß Figur 3 unter Verwendung einer Luftbrücke für die Basisanschlüsse hat insbesondere den Vorteil einer noch besseren Wärmeabfuhr. Die Wärmeabfuhr und Wärmekopplung wird um so effektiver, je großflächiger die gut wärmeleitenden Metallkontakte, auf denen die Luftbrücke aufsetzt, ausgeführt werden können und je näher die Metallkontakte an dem Ort der Wärmeentstehung angeordnet werden können. Bei hohen Leistungen entsteht die meiste Wärme unterhalb der dünnen Basisschicht in der Kollektorschicht. Die Basiskontakte werden daher möglichst nahe (z. B. auch selbstjustiert zum Emitterfinger) symmetrisch um den Emitter als Basisfinger 6 und möglichst großflächig ausgeführt. Es sind damit für Anwendungen im Bereich höchster Frequenzen sehr schmale Emitterfinger realisierbar (z. B. ein Mikrometer breit), so daß die Betriebseigenschaften (performance) im Bereich hoher Frequenzen deutlich verbessert werden. Schmale Emitterfinger führen jedoch zu einem erhöhten thermischen Widerstand. Die zweidimensionale Luftbrücke 10 für die Basis kann auch im Fall besonders schmaler Emitter die erzeugte Wärme besonders effektiv abführen, so daß über den entsprechend gesenkten thermischen Widerstand die Gleichspannungs- und Hochfrequenzeigenschaften des HBT profitieren.

Dieses Ausführungsbeispiel kann entsprechend mit einer Luftbrücke für die Kollektorkontakte abgewandelt werden. Die Luftbrücke überspannt dann vorzugsweise großflächig die Basisanschlußfläche und die Emitteranschlußfläche, über die die Basisfinger bzw. die Emitterfinger angesteuert werden. Die Wärmekopplung (auch mehrerer miteinander verkoppelter Leistungszellen) erfolgt dann über eine auf den Kollektorkontakten 7 aufgebrachte zweidimensionale Luftbrücke, wobei diese Kollektorkontakte 7 möglichst dicht bis an die jeweiligen Basis-Emitter-Komplexe herangeführt sind.

Eine weitere vorteilhafte Ausgestaltung sieht vor, thermisch und ggf. elektrisch leitende Verbindungen durch Durchbrüche im Substrat (via) auf die Substratrückseite zu führen. Derartige Verbindungen 9 sind in Figur 1 und Figur 3 gestrichelt angedeutet. Auf der Rückseite des Substrates kann z. B. ein Masseanschluß vorgesehen sein. Bei Verwendung einer Flip-chip-Technik gewährleistet die zweidimensionale Luftbrücke kürzere Wege für den Abfluss der Wärme, bevor über die relativ hohen Höcker oder Podeste (bumps), die bei der Flip-chip-Technologie zur Montage verwendet werden, die Wärme auf die Wärmesenke übertragen wird. Es ist auch möglich, die Oberseite des Substrates mit der Luftbrücke auf eine Wärmesenke des Gehäuses zu montieren. Kontakte für Basis und Kollektor werden auf Bondpads (Kontaktflächen) aufgebracht, die auf der Substrat-Rückseite vorgesehen werden und die durch Durchbrüche im Substrat (vias) elektrisch leitend mit den Basis- und Kollektorbereichen verbunden werden.

Es genügt im übrigen, wenn auf dem Bauelement auf den Emitterfingern bzw. den Basisfingern bzw. den Kollektorkontakten statt einer vollständigen Luftbrücke zunächst nur die Kontaktpfeiler aufgebracht werden und diese Kontaktpfeiler mit einer Wärmesenke oder Wand eines Gehäuses verbunden werden. Die Wärmesenke oder Wand des Gehäuses bildet dann die zweidimensionale Luftbrücke. In diesem Sinn kann bei der erfindungsgemäßen Leistungstransistorzelle die Luftbrücke also eine Wärmesenke oder ein integraler Bestandteil eines für die Montage verwendeten Gehäuses sein. Wesentlich ist auch hier die großflächige Abmessung der Luftbrücke.

Die bei der erfindungsgemäßen Leistungstransistorzelle vorhandene und anhand der aufgeführten Ausführungsbeispiele beschriebene zweidimensionale Luftbrücke läßt sich sinngemäß auf alle anderen Leistungszellen übertragen: z. B. Leistungsdioden und Diodenarrays auf beliebigem Substratmaterial (z. B. Si, GaAs; Impattdioden, Laserdioden), Leistungstransistoren auf beliebigem Substratmaterial (Bipolartransistoren, MOSFET, MESFET, HEMT, JFET).

Bei der erfindungsgemäßen Leistungstransistorzelle oder einer verkoppelten Anordnung mehrerer solcher Leistungstransistorzellen überragt die Luftbrücke in der Ebene der Oberseite des Chips nach allen Richtungen den kleinsten konvexen Bereich, der von den Kontakten (Emitterfinger, Basisfinger, Kollektorkontakte), auf denen die Luftbrücke aufsitzt, eingenommen wird. Unter einem konvexen Bereich ist dabei eine Fläche zu verstehen, die jede Verbindungsstrecke je zweier ihrer Punkte enthält. Bei einer Leistungstransistorzelle mit einer Anzahl in einer geradlinigen Reihe hintereinander angeordneter Einzeltransistoren und einer Luftbrücke, die auf den Emitterfingern aufsitzt, ist dieser kleinste konvexe Bereich das kleinste Rechteck auf der Chipoberseite, das alle Emitterfinger enthält. Bei mehreren verkoppelten Leistungstransistorzellen enthält der bezeichnete kleinste konvexe Bereich alle Kontaktfinger, auf denen die Luftbrücke aufsitzt.

Ein bevorzugtes Ausführungsbeispiel sieht vor, daß die Luftbrücke in der Längsrichtung der Emitterfinger die Emitterfinger um mindestens 30 % der Länge der Emitterbereiche überragt. Bei Heterobipolartransistoren mit einer typischen Länge der Emitterfinger von etwa 30 µm kann die Luftbrücke auch um 100 % und mehr über die Länge der Emitterbereiche hinausragen. Bei Feldeffekttransistoren sind die Kontaktfinger in der Regel wesentlich länger, z. B. typisch 100 µm oder wenig darunter, wobei dann die Luftbrücke auch wegen des größeren Platzbedarfes der elektrischen Anschlüsse nur mindestens etwa 30 % über die Länge der Kontaktfinger hinausragt. Bei noch längeren Kontaktfingern von z. B. etwa 500 µm kann es erforderlich sein, die Luftbrücke auf eine Abmessung zu begrenzen, die in Richtung der Kontaktfinger nur 15 bis 20 % über die Kontaktfinger hinausgeht.

## Patentansprüche

1. Leistungstransistorzelle aus Einzeltransistoren mit je mindestens einem separaten Anschlußkontakt,
- bei der die Anschlußkontakte untereinander thermisch leitend mittels einer Luftbrücke (1) verbunden sind und
- bei der die Luftbrücke in der Ebene der Kontakte Abmessungen aufweist, die in allen Richtungen über den kleinsten konvexen Bereich, der die betreffenden Kontakte enthält, hinausgehen wobei unter einem konvexen Bereich eine Fläche zu verstehen ist, die jede Verbindungstrecke je zweier ihrer Punkte enthält.

2. Leistungstransistorzelle nach Anspruch 1,
bei der die mit der Luftbrücke verbundenen Anschlußkontakte länglich sind und die Luftbrücke in der Längsrichtung der Kontakte die Kontakte um mindestens 15 % der Länge der Kontakte überragt.

3. Leistungstransistorzelle nach Anspruch 1,
bei der die mit der Luftbrücke verbundenen Anschlußkontakte länglich sind und die Luftbrücke in der Längsrichtung der Kontakte die Kontakte um mindestens 30 % der Länge der Kontakte überragt.

4. Leistungstransistorzelle nach Anspruch 1,
bei der die mit der Luftbrücke verbundenen Anschlußkontakte länglich sind und die Luftbrücke in der Längsrichtung der Kontakte die Kontakte um mindestens 100 % der Länge der Kontakte überragt.

5. Leistungstransistorzelle nach einem der Ansprüche 1 bis 4,
bei der die zur flächigen Ausdehnung der Luftbrücke senkrechte (vertikale) Abmessung der Luftbrücke 20 µm bis 30 µm beträgt.

6. Leistungstransistorzelle nach einem der Ansprüche 1 bis 5,
bei der die Luftbrücke auf einer mit der Leistungstransistorzelle versehenen Oberseite eines Chips mittels thermisch leitfähiger Kontaktpfeiler (8) aufgesetzt ist.

7. Leistungstransistorzelle nach einem der Ansprüche 1 bis 6,
bei der die Luftbrücke auf einer gemeinsamen Anschlußfläche der Anschlußkontakte mittels thermisch leitfähiger Kontaktpfeiler (8) aufgesetzt ist.

8. Leistungstransistorzelle nach Anspruch 7,
bei der die Luftbrücke und die Kontaktpfeiler elektrisch leitend sind und die verbundenen Anschlußkontakte durch die Luftbrücke und die Kontaktpfeiler elektrisch leitend mit der Anschlußfläche verbunden sind.

9. Leistungstransistorzelle nach einem der Ansprüche 1 bis 8,
bei der die Einzeltransistoren Bipolartransistoren sind, die einen Emitter (2), eine Basis (3) und einen Kollektor (4) aufweisen,
- bei der für jeden Transistor mindestens ein Emitterfinger (5) als Anschlußkontakt des Emitters oder ein Basisfinger (6) als Anschlußkontakt der Basis oder ein Kollektorkontakt (7) als Anschlußkontakt des Kollektors vorhanden ist und
- bei der die Emitterfinger oder die Basisfinger oder die Kollektorkontakte untereinander thermisch leitend mittels der Luftbrücke (1) verbunden sind.

10. Leistungstransistorzelle nach Anspruch 9,
bei der die Luftbrücke elektrisch leitend ist und auf einer Emitteranschlußfläche (11), einer Basisanschlußfläche (12) oder einer Kollektoranschlußfläche (13) mittels thermisch und elektrisch leitfähiger Kontaktpfeiler (8) aufgesetzt ist.

11. Leistungstransistorzelle nach Anspruch 9 oder 10,
bei der die Luftbrücke auf den Basisfingern (6) und auf einer Basisanschlußfläche (12) aufgesetzt ist.

12. Leistungstransistorzelle nach Anspruch 11,
bei der die Emitterfinger höchstens 1 µm breit sind.

13. Leistungstransistorzelle nach einem der Ansprüche 1 bis 12,
bei der die Luftbrücke integraler Bestandteil einer Wärmesenke oder eines Gehäuses ist.

14. Leistungstransistorzelle nach einem der Ansprüche 1 bis 13,
die mit anderen Leistungstransistorzellen zu einem Block zusammengeschaltet ist und
die über die Luftbrücke mit den übrigen Leistungstransistorzellen des Blockes thermisch gekoppelt ist.

## Claims

1. Power transistor cell comprising individual transistors each having at least one separate connection contact,
- in which the connection contacts are thermally conductively connected to one another by means of an air bridge (1), and
- in which the air bridge has, in the plane of the contacts, dimensions which exceed the smallest convex region containing the relevant contacts in all directions, a convex region being understood as being a surface which contains each connection path between two of its respective points.

2. Power transistor cell according to Claim 1, in which the connection contacts connected to the air bridge are elongate, and the air bridge protrudes beyond the contacts by at least 15% of the length of the contacts in the longitudinal direction of the contacts.

3. Power transistor cell according to Claim 1, in which the connection contacts connected to the air bridge are elongate, and the air bridge protrudes beyond the contacts by at least 30% of the length of the contacts in the longitudinal direction of the contacts.

4. Power transistor cell according to Claim 1, in which the connection contacts connected to the air bridge are elongate, and the air bridge protrudes beyond the contacts by at least 100% of the length of the contacts in the longitudinal direction of the contacts.

5. Power transistor cell according to one of Claims 1 to 4, in which the dimension of the air bridge perpendicular (vertical) to the areal extent of the air bridge is between 20 µm and 30 µm.

6. Power transistor cell according to one of Claims 1 to 5, in which the air bridge is mounted on a chip top provided with the power transistor cell by means of thermally conductive contact pillars (8).

7. Power transistor cell according to one of Claims 1 to 6, in which the air bridge is mounted on a common connection surface of the connection contacts by means of thermally conductive contact pillars (8).

8. Power transistor cell according to Claim 7, in which the air bridge and the contact pillars are electrically conductive, and the connected connection contacts are electrically conductively connected to the connection surface by the air bridge and the contact pillars.

9. Power transistor cell according to one of Claims 1 to 8, in which the individual transistors are bipolar transistors having an emitter (2), a base (3) and a collector (4),
- in which each transistor is provided with at least one emitter finger (5) as the emitter connection contact or one base finger (6) as the base connection contact or one collector contact (7) as the collector connection contact, and
- in which the emitter fingers or the base fingers or the collector contacts are thermally conductively connected to one another by means of the air bridge (1).

10. Power transistor cell according to Claim 9, in which the air bridge is electrically conductive and is mounted on an emitter connection surface (11), a base connection surface (12) or a collector connection surface (13) by means of thermally and electrically conductive contact pillars (8).

11. Power transistor cell according to Claim 9 or 10, in which the air bridge is mounted on the base fingers (6) and on a base connection surface (12).

12. Power transistor cell according to Claim 11, in which the emitter fingers are at most 1 µm wide.

13. Power transistor cell according to one of Claims 1 to 12, in which the air bridge is an integral component of a heat sink or of a housing.

14. Power transistor cell according to one of Claims 1 to 13, which is connected to other power transistor cells to form a block and which is thermally coupled to the remaining power transistor cells in the block by means of the air bridge.

## Revendications

1. Cellule de transistor de puissance, constituée de transistors individuels ayant respectivement au moins un contact distinct de connexion,
- dans lequel les contacts de connexion sont reliés entre eux d'une manière conductrice thermiquement au moyen d'un pont (1) d'air et
- dans lequel le pont d'air a, dans le plan des contacts, des dimensions qui dépassent dans toutes les directions de la partie convexe la plus petite qui comporte les contacts concernés, une partie convexe devant s'entendre comme étant une surface qui contient chaque zone de liaison de respectivement deux de ses points.

2. Cellule de transistor de puissance suivant la revendication 1,
dans laquelle les contacts de connexion reliés au pont d'air sont oblongs et le pont d'air dépasse, dans la direction longitudinale des contacts, les contacts d'au moins 15 % de la longueur des contacts.

3. Cellule de transistor de puissance suivant la revendication 1,
dans laquelle les contacts de connexion reliés au pont d'air sont oblongs et le pont d'air dépasse, dans la direction longitudinale des contacts, les contacts d'au moins 30 % de la longueur des contacts.

4. Cellule de transistor de puissance suivant la revendication 1,
dans laquelle les contacts de connexion reliés au pont d'air sont oblongs et le pont d'air dépasse, dans la direction longitudinale des contacts, les contacts d'au moins 100 % de la longueur des contacts.

5. Cellule de transistor de puissance suivant l'une des revendications 1 à 4,
dans laquelle la dimension (verticale) du pont d'air perpendiculaire à l'étendue en surface du pont d'air est comprise entre 20 µm et 30 µm.

6. Cellule de transistor de puissance suivant l'une des revendications 1 à 5,
dans laquelle le pont d'air est mis, au moyen d'un pilier (8) de contact conducteur thermiquement, sur un côté supérieur d'une piste, ce côté étant muni de la cellule de transistor de puissance.

7. Cellule de transistor de puissance suivant l'une des revendications 1 à 6,
dans laquelle le pont d'air est mis, au moyen d'un pilier (8) de contact conducteur thermiquement, sur une surface de connexion commune des contacts de connexion.

8. Cellule de transistor de puissance suivant la revendication 7,
dans laquelle le pont d'air et les piliers de contact sont conducteurs de l'électricité et les contacts de connexion reliés sont reliés par le pont d'air et les piliers de contact sont reliés d'une manière conductrice de l'électricité à la surface de connexion.

9. Cellule de transistor de puissance suivant l'une des revendications 1 à 8,
dans laquelle les transistors individuels sont des transistors bipolaires qui ont un émetteur (2), une base (3) et un collecteur (4),
- dans lequel, pour chaque transistor, au moins un doigt (5) d'émetteur est présent en tant que contact de connexion de l'émetteur ou un doigt (6) de base en tant que contact de connexion de la base, ou un contact (7) de collecteur en tant que contact de connexion du collecteur et
- dans lequel le doigt d'émetteur ou le doigt de base ou le contact de collecteur sont reliés entre eux d'une manière conductrice thermiquement au moyen du pont (1) d'air.

10. Cellule de transistor de puissance suivant la revendication 9,
dans laquelle le pont d'air est conducteur de l'électricité et est mis, au moyen de piliers (8) de contact conducteurs du point de vue thermique et du point de vue électrique, sur une surface (11) de connexion d'émetteur, sur une surface (12) de connexion de base ou sur une surface (13) de connexion de collecteur.

11. Cellule de transistor de puissance suivant la revendication 9 ou 10,
dans laquelle le pont d'air est mis sur les doigts (6) de base et sur une surface (12) de connexion de base.

12. Cellule de transistor de puissance suivant la revendication 11,
dans laquelle les doigts d'émetteur ont une largeur de 1 µm au plus.

13. Cellule de transistor de puissance suivant l'une des revendications 1 à 12,
dans laquelle le pont d'air fait partie intégrale d'un puits de chaleur ou d'un boîtier.

14. Cellule de transistor de puissance suivant l'une des revendications 1 à 13,
qui est interconnectée avec d'autres cellules de transistor de puissance en un bloc et qui est couplée thermiquement par le pont d'air avec les autres cellules de transistor de puissance du bloc.
